# EUROPEAN PATENT SPECIFICATION

(11) **EP 3 991 971 B1**
(45) Date of publication and mention of the grant of the patent: **13.11.2024**
(21) Application number: 21171807.7
(22) Date of filing: 03.05.2021
(51) Int. Cl.: B32B 37/10, B30B 15/06, B30B 7/02

(54) **PLATE PRESSING TYPE LAMINATOR AND PRESSURE APPLYING METHOD**
PLATTENPRESSENLAMINATOR UND DRUCKAUFBRINGUNGSVERFAHREN
LAMINATEUR DU TYPE À PRESSAGE DE PLAQUE ET PROCÉDÉ D'APPLICATION DE PRESSION

(30) Priority: 28.10.2020 CN 202011175993; 08.02.2021 CN 202110172250
(43) Date of publication of application: 04.05.2022
(73) Proprietor: Qinhuangdao Visual Automation Equipment Co. Ltd., Economic and Technological Development Zone Qinhuangdao City Hebei 066303 (CN)
(72) Inventor: LIU, Xiaoyong, Qinhuangdao City (CN); HAN, Xing, Qinhuangdao City (CN); CHAI, Xinggang, Qinhuangdao City (CN); LIU, Boming, Qinhuangdao City (CN)
(74) Representative: Grünecker Patent- und Rechtsanwälte PartG mbB

(56) References cited:
- EP-A2- 1 609 597
- EP-A2- 2 145 753
- DE-B4- 102009 042 148
- US-A1- 2008 295 956
- US-A1- 2009 242 137

## Description

### TECHNICAL FIELD

The present invention relates to a plate pressing type laminator and a pressure applying method.

### BACKGROUND

With development of solar cell module technology, requirements from module manufacturers for laminators are constantly changing, and laminating apparatuses are developing in the direction of higher efficiency, higher productivity and lower operating cost. In order to adapt to the above requirements, the manufacturers have designed a multi-layer laminator, which includes a plurality of vertically arranged lamination cavities. Each lamination chamber is internally provided with a module, and applies a pressure to the module. The multi-layer laminator with the above structure has the advantages of small occupied area and high production efficiency due to the fact that a pressing area of the laminator accommodated per square meter is large, and more modules can be pressed by using the plurality of cavities at one time. However, in the prior art, in order to realize a high vacuum degree of a first chamber, the first chamber is usually pressed with membrane. For example, the Chinese patent application No. "201010190162.8", with date of announcement on 30th November, 2011, entitled Solar Module Laminator and Lamination Method Thereof. With the laminator with such a structure, a membrane divides the laminator into an upper chamber and a lower chamber, and a workpiece is placed on a heating plate of the lower chamber. The lower chamber is vacuumized to remove bubbles from each layer of the module before lamination, and the upper chamber is inflated during lamination, such that the membrane swells downwards to press on the surface of the module.

DE 10 2009 042148 B4 discloses a stack press for producing plate-shaped workpieces from composite material by means of pressure and heat. The stack press comprises a hydraulic unit, floor elements and a flexible pressing device. The hydraulic unit isprovided at the bottom for lifting and lowering device, for opening and closing the floor elements and to provide at least some axial pressure. The flexible pressing device is provided on top of the floor elements to provide additional axial pressure. The floor elements are provided to form an evacuable volume created between the two floor elements (including heating element) sealed by sealing elements and a transport means fixed on the upper run of the conveyor unit. When the floor elements are brought together completely, an axial pressing pressure can be also generated partially by the hydraulic unit, partly by the flexible pressing device, and partly by the vacuum pressure.

US 2008/295956 A1 discloses a multiple-stage laminator, wherein the plate-shaped workpieces are prelaminated in a multi-stage vacuum lamination press, which provides a vacuum chamber that is sealed by sealing frames and divided by a flexible pressure member into a product half and a pressure half under the effect of heat. The product half is evacuated and presses the workpiece directly or indirectly against a bottom side of the vacuum chamber due to the resulting low pressure and/ or due to an additional pressurization of the pressure half of the vacuum chamber.

US 2009/242137 A1 discloses a stack laminator, which comprises multiple vertically stacked laminating units. A pressing member is provided in the upper chamber and stacked above a lower chamber provided with a heating plate. A workpiece is set on the heating plate and pressed between the upper and lower chambers, which can be closed and sealed. It further discloses an opening and closing device with a ball screw and a servo motor as an elevator device, whereby horizontally extendable flange members are provided to support cases of the chambers.

EP 1 609 597 A2 discloses a laminator, which consists of at least one laminating chamber with a stack of laminating plates arranged in tiers therein. A pressing device is formed by a membrane stretched tightly on a membrane frame. By venting the previously evacuated chamber above the membrane, the membranes as a pressing device exert a flat pressing force on the component with its laminate layers lying below the membrane in each case. For the laminators discussed above, the membrane is used to apply a press to the module, the membrane forms a cambered surface when swelling, so a pressure on the surface of the module is inconsistent, which makes corners be prone to generate bubbles, sides to open and corners to warp. In addition, during production of new modules, due to reduction of a glass thickness, change of a foil, etc., a lamination process zone is narrowed, so it is more difficult to select process parameters. For example, a glass thickness of a module produced at present is reduced, PVB foil is needed for bonding, so the greater pressure during pressing is required, which was always smaller than standard atmospheric pressure in the past, and is required to be greater than the standard atmospheric pressure now. The greater the pressure applied, the higher the elastic requirement for the membrane is; otherwise the membrane cannot bear the pressure and therefore be damaged. So, the requirement for the quality of the membrane is getting higher and higher, and the service life of the membrane is getting shorter and shorter. The membrane needs to be frequently replaced as consumables. With decrease of the glass thickness, consumption of the membrane will be greater, which will increase the production and operation cost. However, with increase of an applied pressure, the membrane cannot bear the pressure any longer, so it is urgent to provide renewed products to meet the production needs.
EP 2145 753 A2 discloses a multi-level laminating press, comprising weight compensation elements provided as resilient stop elements mounted in opposition to the press base and/or the upper press part, wherein the exact position of one end of the mounting on the upper press part is completely missing and is by any way impossible to be fixedly mounted.

### SUMMARY OF INVENTION

An objective of the present invention is to provide a plate pressing type laminator and a pressure applying method for laminating a plate-shaped member aimed at the defects that a membrane is prone to damage, a corner of a laminated module is prone to generate bubbles, and a side of the module is prone to open when a laminator and a laminating method in the prior art are used for lamination.

The objective of the present invention, as defined in the appended claims, is achieved through the following technical solution the plate pressing type laminator comprises a lift driving device and a plurality of plate-shaped pressing members which are sequentially arranged from top to bottom, wherein a chamber for accommodating a workpiece is formed in a space between every two adjacent plate-shaped pressing members when they are pressed against each other, the chamber forming a pressing layer; and the lift driving device drives the plurality of plate-shaped pressing members to press against one another or move away from one another and provides a pressure for mutual pressing, and the workpiece is pressed through the pressure between the plate-shaped pressing members.

An elastic member is arranged between adjacent plate-shaped pressing members, wherein the elastic member is an elastic sealing member, and when the adjacent plate-shaped pressing members press against each other, the elastic sealing member completely or intermittently seals the chamber formed by the space between the adjacent plate-shaped pressing members ; and the laminator is provided with a vacuumizing interface and a vacuumizing channel, the vacuumizing interface and the vacuumizing channel being used to be connected to a vacuumizing device, so as to vacuumize the chamber.

The plate pressing type laminator further comprises an upper cover, a base, an upright post and a closing positioning and supporting device, wherein the upper cover is located above an uppermost plate-shaped pressing member, the base is located below a lowermost plate-shaped pressing member, and each plate-shaped pressing member is connected to the upright post in an up-and-down sliding manner through a sliding connection structure;
the lift driving device drives the upper cover and the base to get close to each other to drive the plate-shaped pressing members to press against one another, so as to enable the pressing layer to be closed for pressing; and when the pressing layer is closed, the closing positioning and supporting device supports each plate-shaped pressing member.

The closing positioning and supporting device of a plate-shaped pressing member located in the middle comprises a jacking block and a jacking oil cylinder or air cylinder, a cylinder body of the jacking oil cylinder or air cylinder is fixedly arranged on the base, the jacking block is respectively arranged in a position, corresponding to the jacking oil cylinder or air cylinder, on each plate-shaped pressing member located in the middle, and when the pressing layers are closed, a cylinder rod of the jacking oil cylinder or air cylinder jacks the jacking block of the corresponding plate-shaped pressing member; and
the closing positioning and supporting device of the uppermost plate-shaped pressing member comprises an oil cylinder or an air cylinder, a cylinder body of the oil cylinder or the air cylinder being fixedly arranged on the upper cover, and a cylinder rod of the oil cylinder or the air cylinder being fixedly connected to the uppermost plate-shaped pressing member.

Optionally, the vacuumizing interface is arranged on any plate-shaped pressing member, the plate-shaped pressing member provided with the vacuumizing interface is provided with the vacuumizing channel, and each plate-shaped pressing member located between the uppermost plate-shaped pressing member and the lowermost plate-shaped pressing member is provided with a vent hole at an inner side of the elastic sealing member.

Optionally, a first sealing member is arranged between the base and the lowermost plate-shaped pressing member, a second sealing member is arranged between the upper cover and the uppermost plate-shaped pressing member, when the pressing layers are closed, a gap between the base and the lowermost plate-shaped pressing member is sealed by the first sealing member, a gap between the upper cover and the uppermost plate-shaped pressing member is sealed by the second sealing member, the vacuumizing interface and the vacuumizing channel are arranged on the base and/or the upper cover, and a vent hole is provided on each plate-shaped pressing member between the base and the upper cover at an inner side of the elastic sealing member.

Optionally, after the plate-shaped pressing members being separated, each plate-shaped pressing member located between the uppermost plate-shaped pressing member and the lowermost plate-shaped pressing member is supported by a cover opening support device for each plate-shaped pressing member.

Optionally, the cover opening support device is a baffle block, and the baffle block of each plate-shaped pressing member is arranged on the upright post, and each plate-shaped pressing member is positioned above the corresponding baffle block and supported by the baffle block.

Optionally, the lift driving device is an oil cylinder or an air cylinder, a surface, opposite the plate-shaped pressing member, of the upper cover and a surface, opposite the plate-shaped pressing member, of the base are flat planes, the upper cover is fixedly arranged, and a cylinder body of the oil cylinder or the air cylinder is fixedly connected to the base.

Optionally, a sealed groove is provided at the periphery of a lower surface of the plate-shaped pressing member, and the elastic sealing member is an inflatable sealing ring, one end of inflatable sealing ring being located inside the sealed groove and the other end being located outside the sealed groove.

Optionally, two ends of each plate-shaped pressing member located below the uppermost plate-shaped pressing member are respectively provided with a driving shaft and a driven shaft, and a conveyor belt is arranged around the driving shaft and the driven shaft, and the conveyor belt is driven by a driving device to move around the plate-shaped pressing member; and/or
a heating or cooling device is arranged on the plate-shaped pressing member.

Optionally, a plurality of lift driving devices are arranged, and each lift driving device realizes synchronous movement through a synchronization device, and the lift driving device is a lift oil cylinder or air cylinder.

The invention further provides the pressure applying method for laminating the plate-shaped member, and by using the plate pressing type laminator as described above, the method includes: placing a plate-shaped workpiece between adjacent plate-shaped pressing members, and driving, through the lift driving device, the plate-shaped pressing members to get close to and press one another, so as to apply a pressure to the workpiece.

Optionally, the plate-shaped workpiece includes plates and an interlamellar bonding layer between the plates, the plate-shaped workpiece is arranged between two plate-shaped pressing members, and the plate-shaped pressing members are driven to get close to and press one another, so as to apply the pressure to the plate-shaped workpiece.

Optionally, at least two plate-shaped pressing members arranged up and down are arranged between a base and an upper cover, and the upper cover and the base are driven to get close to each other by a driving device, so as to push the plate-shaped pressing members to get close to and press one another and apply the pressure to the plate-shaped member.

Optionally, the chamber for accommodating the plate-shaped workpiece is formed between the plate-shaped pressing members through an elastic sealing ring, a height of the chamber is greater than a thickness of the accommodated plate-shaped workpiece, a gap between the base and its adjacent plate-shaped pressing member is sealed by a sealing member, and a gap between the upper cover and its adjacent plate-shaped member is sealed by a sealing member. During pressure applying, each plate-shaped pressing member is supported by a closing positioning and supporting device thereof. The closing positioning and supporting device provides supporting force, greater than or equal to a gravity of the plate-shaped pressing member, for the plate-shaped pressing member, and each chamber accommodating the plate-shaped workpiece is in air communication with one another, and is in communication with a sealed chamber between the base and the upper cover, and the chamber is vacuumized during and/or before pressure applying.

Optionally, a pressed plate-shaped workpiece is a photovoltaic cell module, and the photovoltaic cell module is subjected to pressure applying through the pressure applying method.

In heating and curing steps, the photovoltaic cell module is placed in a sealed lamination chamber, the lamination chamber is vacuumized to make the photovoltaic cell module in a vacuum environment, and the photovoltaic cell module is subjected to heating, curing and pressure applying while the lamination chamber is vacuumized.

Optionally, in the pressure applying method, two or more plate-shaped pressing members are arranged, and every two opposite plate-shaped pressing members form one pressing layer, and when being vacuumized, all the pressing layers are simultaneously vacuumized.

By using the laminator provided by the present invention, the oppositely arranged plate-shaped pressing members form a working chamber to sandwich the workpiece, and the plate-shaped pressing members press each other through mechanical external force to apply a pressure to the workpiece, the workpiece and the plate-shaped pressing member is in surface contact, such that pressure on each point is good in consistence, interlamellar bubbles retained are easy to discharge, bubbles are not prone to be generated at corners and the corners are not prone to open; when the mechanical external force is used for applying the pressure during pressure applying, and a direct pressure applying member is the plate-shaped pressing member, which has a good bearing capacity and may bear a greater pressure compared with a membrane; a pressure output device such as an oil cylinder/air cylinder is used as an external force pressure applying device for the mechanism, such that an output pressure is stable and reliable, and the plate-shaped pressing member and the workpiece are merely separated by a conveyor belt instead of the thick membrane, such that heat conduction is fast and the heating efficiency is high.

When each pressing layer is closed, the elastic sealing member arranged below the upper plate-shaped pressing member first comes into contact with the lower plate-shaped pressing member, then the plate-shaped pressing member comes into contact with the workpiece, such that the workpiece is not prone to be damaged due to flexible contact.

The workpiece is subjected to press applying by adopting the pressure applying method of the present invention, the plate-shaped pressing members are pushed by the mechanical external force to get close to each other and press the workpiece, the contact between the workpiece and the plate-shaped pressing members is plate contact, such that compared with inflation pressing by using the membrane, pressure uniformity is better, the range of pressing is not limited, and pressing is fast;
when a photovoltaic module is subjected to hot pressing, curing and pressure applying with the pressure applying method of the present invention, pressure applying is performed through press between the plate-shaped pressing members instead of a traditional membrane, such that the plate-shaped pressing member is pressed at both sides, and is strong in bearing capacity and not prone to damage accordingly, and compared with pressure applying using the membrane, a pressure applying speed is improved, consumption of the membrane is avoided, so the more economical effect is achieved; and

By using the method of the present invention for applying the pressure, the plate-shaped member is placed between two plate-shaped pressing members, such that a plurality of plate-shaped members may be subjected to pressure applying at one time, the efficiency is high and an occupied area is small.

### BRIEF DESCRIPTION OF THE DRAWINGS

Fig. 1 is a structural schematic diagram of a plate pressing type laminator according to an embodiment of the present invention;
Fig. 2 is a structural schematic diagram of a plate pressing type laminator according to another embodiment of the present invention;
Fig. 3 is a structural schematic diagram of a plate pressing type laminator according to the present invention, with a sealed chamber in a opened state;
Fig. 4 is a schematic diagram of the sealed chamber, in a closed state, of the plate pressing type laminator shown in Fig. 3;
Fig. 5 is schematic diagram of a connection structure between a synchronous transmission device and a base, showing a structure of the synchronous transmission device; and
Fig. 6 is a top view of Fig. 5.

Description of reference numerals:
100-frame 101-base 102-upper cover 103-upright post 104-cover opening support device 105-lift frame 106-sealing strip
200-closing positioning and supporting device 201-jacking oil cylinder/air cylinder 201A-second jacking oil cylinder/air cylinder 201B-third jacking oil cylinder/air cylinder 202-telescopic oil cylinder/air cylinder 203-jacking block 203A-second jacking block 203B-third jacking block 201A-second jacking oil cylinder/air cylinder 201B-third jacking oil cylinder/air cylinder 4002-second lamination working layer,
300-lift driving device 301-lift oil cylinder/air cylinder 302-synchronization device 321-rack 3022-gear 3023-gear shaft 3024-bevel gear 3025-intermediate transmission shaft
400-lamination working layer 401-plate-shaped pressing member 402-driving shaft 403-conveyor belt 404-driven shaft 405-tension air cylinder 406-elastic sealing member 407-vent hole 4001-bottom lamination working layer
4002-second lamination working layer 4003-third lamination working layer 4011-bottom-layer plate-shaped pressing member 4014-top-layer plate-shaped pressing member.

### DESCRIPTION OF THE EMBODIMENTS

The following will describe structures and principles of the present invention in detail with reference to accompanying drawings.

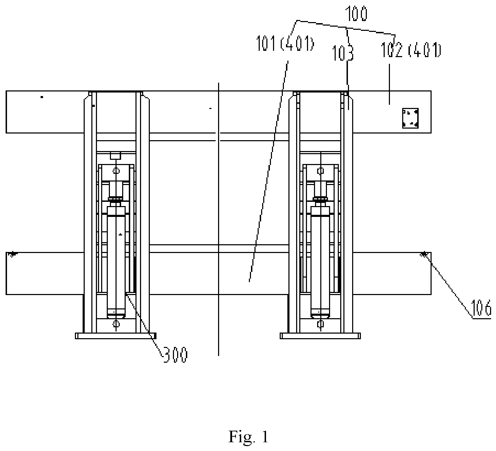

As shown in Figs. 1-6, for the convenience of description, an operation direction of a conveyor belt 403 is called a length direction of the conveyor belt on a horizontal plane, and a direction perpendicular to the operation direction of the conveyor belt is called a width direction of the conveyor belt.

A plate pressing type laminator of the present invention is used for pressing a laminated plate with an interlamellar bonding layer. Various types of plate pressing type laminators with different purposes may be manufactured by arranging different configurations, such as a laminator for pressing a common plate-shaped object, and a hot-pressing curing laminator and a cold press used in production of a photovoltaic module. It should be noted in advance that a shape of a plate-shaped pressing member in the present invention does not mean that the press member is a plate, but that a working surface of the plate-shaped pressing member is a surface adapted to a contact surface of a workpiece. For example, in order to ensure a strength, a top-layer plate-shaped pressing member may be composed of a plate and a reinforced frame, among which the plate is located on an inner side of the top-layer plate-shaped pressing member, and a bottom-layer plate-shaped pressing member may also be composed of a plate and a reinforced frame, among which the plate is located on an inner side of the bottom-layer plate-shaped pressing member.

As shown in Fig. 1, the plate pressing type laminator of the present invention includes at least two lamination working layers 400 arranged up and down in pairs, each lamination working layer at least includes a plate-shaped pressing member 401, at least the bottommost or topmost plate-shaped pressing member may be fixed, and the rest plate-shaped pressing members are slidably connected to an upright post 103 through a sliding connection structure, at least a bottom-layer or top-layer plate-shaped pressing member may move up and down, thereby realizing mutual pressing between the plate-shaped pressing members. A lift driving device 300 drives the top-layer or the bottom-layer plate-shaped pressing member 401 to descend or ascend, so as to push the plate-shaped pressing members located in the middle to slide along the upright post to get close to and press one another. Alternatively, all the plate-shaped pressing members are slidably connected to the upright post, the bottom-layer and top-layer plate-shaped pressing members are simultaneously driven, by the driving device, to ascend and descend, such that the plate-shaped pressing members get close to and press one another. In the plate pressing type laminator with this structure, the bottom-layer plate-shaped pressing member also serves as a base 101 of the plate pressing type laminator, and the top-layer plate-shaped pressing member also serves as an upper cover 102. The lift driving device 300 preferably uses a hydraulic driving device, a cylinder rod is connected to a driven plate-shaped pressing member, and an air cylinder may be certainly used for driving. A plurality of lift driving devices may be arranged to simultaneously drive the top-layer or the bottom-layer plate-shaped pressing member 401 to descend or ascend. When the plurality of lift driving devices are arranged, it is preferable to arrange a synchronization device which enables the lift driving devices to perform synchronous driving. There is a certain gap between the plate-shaped pressing members which are oppositely arranged up and down, the gap between two plate-shaped pressing members forms a chamber for accommodating a workpiece, and each chamber forms an pressing layer. When three or more plate-shaped pressing members are arranged, a pressing layer is formed between every two adjacent plate-shaped pressing members. At this time, the middle plate-shaped pressing member forms a pressing layer with the upper plate-shaped pressing member, and also forms a pressing layer with the plate-shaped pressing member located below the middle plate-shaped pressing member, or the plate-shaped pressing members in pairs may form pressing layers. At this time, to form two or more pressing layers, it is necessary to at least arrange three plate-shaped pressing members. The plate pressing type laminator of this structure may apply a pressure to a plate-shaped member which needs flat pressing. For example, in the field of photovoltaic production, a laminated and cured photovoltaic module is subjected to pressure applying to be further flattened in side, so as to prevent the side from warping, for example, lamination performed, during manufacturing of a composite floor, for increasing flatness of the floor and eliminating a stress inside the composite floor. When a plurality of pressing layers are arranged, a cover opening support device 104 is arranged, and in a cover opening state, each movable plate-shaped pressing member is supported by the cover opening support device to keep a distance H of one plate-shaped pressing member from another one. In the present invention, the plate-shaped pressing members are driven by the lift driving device, so as to press one another to apply a lamination pressure to the workpiece. With this structure, a driving device with suitable power may be selected according to different pressed workpieces, and different power is output to apply a required pressure to the workpiece, particularly when used to apply the pressure to the photovoltaic module, compared with pressure applying by using a membrane pressing laminator, the laminator may apply a pressure greater than standard atmospheric pressure, thereby greatly enriching types of pressed battery modules and making combination and selection of process parameters easier.

When the laminator is used for pressing a fragile workpiece, such as the photovoltaic module, in order to reduce a breakage rate of a laminated workpiece, it is better to arrange an elastic member between two adjacent plate-shaped pressing members, which may be arranged on one of the plate-shaped pressing members, for example, on the periphery of a lower surface of an upper plate-shaped pressing member or on the periphery of an upper surface of a lower plate-shaped pressing member. When two adjacent plate-shaped pressing members get close to each other to a state in which a gap between the press members is completely closed or partially closed by an elastic member, the state is a closed state, and a height of the chamber is greater than or equal to a height of the workpiece. The elastic member may be continuously arranged along a side of the plate-shaped pressing member or intermittently distributed at the side of the plate-shaped pressing member, and intermittently close the gap between two plate-shaped pressing members when intermittently distributed at the side of the plate-shaped pressing member. The elastic member 406 is arranged between the two adjacent plate-shaped pressing members. When the pressing layer is closed, the elastic member first comes into contact with the plate-shaped pressing member, and when pressing is performed, the elastic member performs elastical supporting to buffer impact force between the plate-shaped pressing member and the workpiece and reduce the breakage rate of fragile members such as the photovoltaic module. The elastic member is preferably an elastic sealing member, such that when the two adjacent plate-shaped pressing members get close to each other, the gap between the press members is sealed by the elastic sealing member to form a sealed chamber, and such a sealed structure is relatively favorable when the photovoltaic module is pressed.

When the elastic member arranged between the adjacent plate-shaped pressing members is an elastic sealing member, in other words, when the pressing layer is closed to form a sealed chamber, a vacuumizing structure may also be arranged to vacuumize the chamber. The vacuumizing structure includes a vacuumizing interface and a vacuumizing channel (neither of which is shown in the figure). The vacuumizing interface may be arranged on a side surface of the plate-shaped pressing member, a body of at least one plate-shaped pressing member of each pressing layer is provided with the vacuumizing channel and the vacuumizing interface which are in communication with the chamber, and the vacuumizing interface is in communication with a vacuumizing device. When a plurality of pressing layers are arranged, a chamber of each pressing layer is relatively independently sealed, and the vacuumizing device is in separate communication with the chamber of each pressing layer, and may respectively vacuumize the chamber of each layer. Each pressing layer may also be provided with a unified vacuumizing interface, each plate-shaped pressing member located between the bottom layer and the top layer is provided with a vent hole 407 in communication with the pressing layer, and when the pressing layer is closed, a gap between the plate-shaped pressing members may be sealed through the elastic sealing ring, and gaps between the top-layer and the bottom-layer plate-shaped pressing members and adjacent plate-shaped pressing members may be respectively sealed by sealing strips. At this time, the vacuumizing interface and the vacuumizing channel may be arranged on any plate-shaped pressing member, and each pressing layer is in communication with the vacuumizing device through the vacuumizing interface, and is in communication with an inner chamber of each pressing layer through the vacuumizing channel and the vent hole, such that each pressing layer may be vacuumized uniformly. The plate pressing type laminator with this structure is preferably provided with the base 101 and the upper cover 102, the base 101 is arranged below the bottom-layer plate-shaped pressing member 401, and the upper cover 102 is arranged above the top-layer plate-shaped pressing member 401. The upper surface and the lower surface of the plate-shaped pressing member are both plate-shaped, and inner sides of the base and the upper cover are both provided with planes for supporting the plate-shaped pressing member. In the cover opening state, each plate-shaped pressing member is supported at a certain position by the cover opening support device 104. A sealing strip 106 is arranged on an upper surface of the base or a lower surface of the bottom-layer plate-shaped pressing member to seal a gap between the upper surface of the base and the lower surface of the bottom-layer plate-shaped pressing member, and a sealing strip 106 is arranged on a lower surface of the upper cover or an upper surface of the top-layer plate-shaped pressing member to seal a gap between the lower surface of the upper cover and the upper surface of the top-layer plate-shaped pressing member. A first sealed chamber is formed between the bottom-layer plate-shaped pressing member and the base, and a second sealed chamber is formed between the top-layer plate-shaped pressing member and the upper cover. The vacuumizing channel is preferably arranged on the fixed base or the upper cover. The vent hole is arranged on an inner side of the elastic sealing member, on each plate-shaped pressing member and along a thickness of the plate-shaped pressing member, such that the chamber of each pressing layer is in communication with one another through the vent holes, and is in communication with the first sealed chamber formed between the base and the bottom-layer plate-shaped pressing member and the second sealed chamber formed between the upper cover and the top-layer plate-shaped pressing member. Workpiece pressing is not performed in the first sealed chamber and the second sealed chamber, and the purpose of arranging the first sealed chamber and the second sealed chamber is to make pressures on both sides of each plate-shaped pressing member consistent and reduce deformation of the plate-shaped pressing member. Each pressing layer is provided with a closing positioning and supporting device 200. When each layer is closed, the closing positioning and supporting device supports the plate-shaped pressing member of each pressing layer so as to make the plate-shaped pressing member of each lamination working layer keep a proper distance Δh, and bear gravity of each plate-shaped pressing member and gravity of other parts and devices carried on the plate-shaped pressing member, and such a distance Δh is usually slightly larger than a thickness of a thickest workpiece to be laminated. The synchronization device is preferably arranged to make the plate-shaped pressing member ascend synchronously.

During automatic production operation, it is necessary to automatically convey in and out the workpiece. Preferably, a conveyor belt 403 is arranged on each plate-shaped pressing member located below, that is, the plate-shaped pressing member excluding the top-layer one, the conveyor belt conveys the workpiece to the upper surface of the plate-shaped pressing member and supports the workpiece together with the plate-shaped pressing member. During production of the photovoltaic module, the conveyor belt is preferably an annular high-temperature resistant cloth conveyor belt, and circumferentially arranged on the plate-shaped pressing member. At this time, it is better to arrange a conveyor belt on the top-layer plate-shaped pressing member. When the laminator is closed, the conveyor belt on the upper plate-shaped pressing member covers the workpiece, which may prevent pressed glue from sticking to the surface of the plate-shaped pressing member during lamination.

The above elastic sealing member, the conveyor belt and the vacuumizing structure or device may be combined with the most basic lamination structure alone, or may be combined with a basic structure in pairs or simultaneously combined with the basic structure to form a plate pressing type laminator with different functions and uses.

When the plate pressing type laminator is used for different purposes, a cooling device may be arranged in a body of the plate-shaped pressing member to form a cooling plate, or a heating device may be arranged in the plate-shaped pressing member, such that the plate-shaped pressing member forms a heating plate. In the field of photovoltaic production, the cooling plate and the heating plate are common components, whose specific structures will not be described any more. The following will describe, through particular embodiments, different structures of the plate pressing type laminator for different uses of the present invention in detail.

### Embodiment 1

As shown in Fig. 1, the plate pressing type laminator includes an upper cover 102 and a base 101, a lower surface of the upper cover is provided with a surface matching an upper surface of a workpiece, an upper surface of the base is provided with a surface matching a lower surface of the workpiece, and the upper cover is supported by an upright post 103. For example, when the workpiece is a flat-plate workpiece such as a composite floor, inner surfaces of the base and the upper cover are both planes. The upper cover is arranged to be fixed, the base is arranged to be movable, and the base is connected to a cylinder rod of a lift oil cylinder as a lift driving device 300. A sealing strip may further be arranged on the upper surface of the base to seal the base and the upper cover. The plate pressing type laminator may press the composite floor and simply press a cured photovoltaic module.

### Embodiment 2

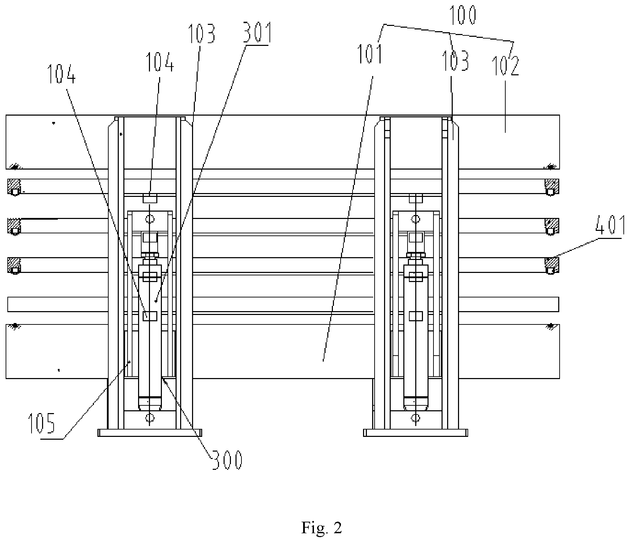

As shown in Fig. 2, on the basis of a structure of embodiment 1, at least one plate-shaped pressing member 401 is arranged between a base 101 and an upper cover 102, and an upper surface and a lower surface of the plate-shaped pressing member are both planes. Two upright posts 103 are arranged on a left side and a right side of a machine frame, and baffle blocks equal in number to the plate-shaped pressing member are arranged at intervals on a side, facing the plate-shaped pressing member, in a height direction of the upright post. The baffle blocks on all the upright posts are arranged in a one-to-one correspondence manner to form the same layer of baffle blocks. The baffle block is used as a cover opening support device, the plate-shaped pressing members of each pressing layer are all seated on the same layer of baffle blocks, and supported by the baffle blocks. A distance between the baffle blocks makes a distance between the plate-shaped pressing members greater than the maximum thickness of the workpiece. A slide rail is arranged on the upright post, and a slide block is arranged on each plate-shaped pressing member, and the plate-shaped pressing member is connected to the upright post in a sliding fit manner through the slide rail and the slide block. The plate pressing type laminator with the structure of this embodiment is used to mainly press a plate-shaped member and performs multi-layer lamination. A lift driving device drives the base to get close to the upper cover, a bottom-layer plate-shaped pressing member slides upwards along the upright column under push of the base, and pushes a plate-shaped pressing member above to move upwards together when encountering the plate-shaped pressing member above, and finally, all the plate-shaped pressing members press against one another, and then an air cylinder exerts external force to continuously push each plate-shaped pressing member to make each plate-shaped pressing member press one another, so as to complete pressing. This plate pressing type laminator is a multi-layer laminator, which may laminate a plurality of plate-shaped members at the same time.

### Embodiment 3

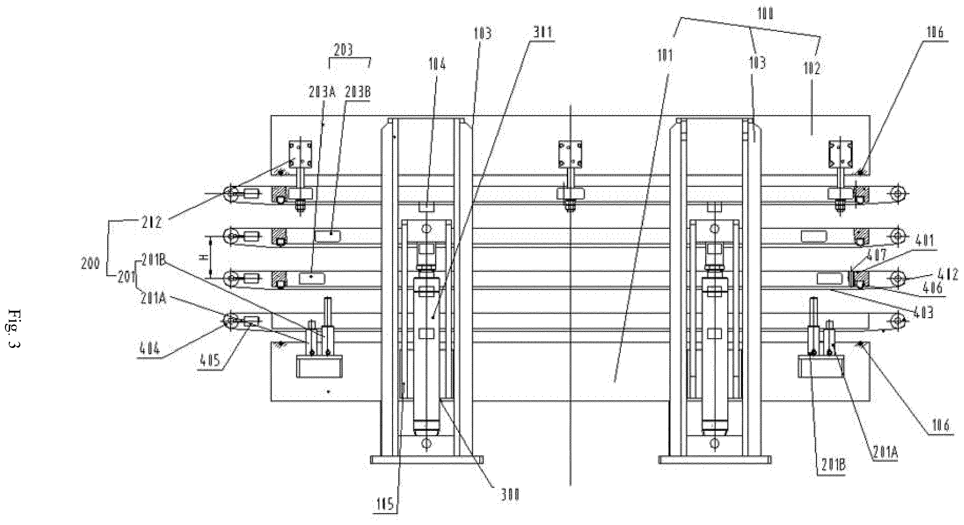

As shown in Fig. 3, on the basis of Embodiment 2, a jacking air cylinder 201 is arranged on a base, the number of the jacking air cylinder 201 is same as that of a plate-shaped pressing member located between a bottom-layer plate-shaped pressing member and a top-layer plate-shaped pressing member, each plate-shaped pressing member located in the middle layer is provided with a jacking block, such that each jacking air cylinder corresponds to one plate-shaped pressing member located in the middle, and an extension length of a cylinder rod of the jacking air cylinder is related to a position of a corresponding plate-shaped pressing member thereof. When the laminator is closed, the cylinder rod of the jacking air cylinder jacks the corresponding jacking block. A telescopic air cylinder is arranged on an upper cover, a cylinder body of air cylinder is fixedly connected to the upper cover, and the cylinder rod is connected to the top-layer plate-shaped pressing member. When the plate pressing type laminator with this structure used is closed, each jacking air cylinder may output force same as the sum of a weight of the corresponding plate-shaped pressing member and a weight carried thereon, the telescopic air cylinder may output pulling force equal to the sum of a weight of the top-layer plate-shaped pressing member and a weight carried thereon, thus reducing a load of a lift air cylinder, making pressures carried by both sides of each plate-shaped pressing member consistent at the same time, reducing or preventing deformation of the plate-shaped pressing member and avoiding the plate-shaped pressing member from bearing an excessive pressure at the same time.

### Embodiment 4

On the basis of Embodiment 2 or 3, an elastic member is respectively arranged below an upper plate-shaped pressing member and near an edge of the plate-shaped pressing member, or located above a lower plate-shaped pressing member and near an edge of the plate-shaped pressing member, of each pressing layer, one end of the elastic member is arranged in a sealed groove and the other end is arranged outside the sealed groove, and a height, outside the plate-shaped pressing member, of the elastic member should meet the following requirements: when a laminator is closed, two oppositely arranged plate-shaped pressing members and the elastic member form a chamber with a height greater than or equal to a thickness of an accommodated workpiece. Herein, the elastic member may be an elastic strip, a leaf spring, a compression spring, etc.

### Embodiment 5

On the basis of Embodiment 2 or 3, an elastic sealing member is respectively arranged below an upper plate-shaped pressing member and near an edge of the plate-shaped pressing member, or located above a lower plate-shaped pressing member and near an edge of the plate-shaped pressing member, of each pressing layer, one end of the elastic sealing member is arranged in a sealed groove and the other end is arranged outside the sealed groove, and a height, outside the plate-shaped pressing member, of the elastic sealing member should meet the following requirements: when a laminator is closed, two oppositely arranged plate-shaped pressing members and the elastic member form a chamber with a height greater than or equal to a thickness of an accommodated workpiece.

### Embodiment 6

On the basis of Embodiment 5, a fixed upper cover is provided with a vacuumizing interface and a vacuumizing channel, the vacuumizing interface is in communication with the interior of a chamber through the vacuumizing channel, sealing strips are arranged on the periphery of a lower surface of the upper cover and the periphery of an upper surface of a base, and a vent hole 407 is provided on a portion, on an inner side of an elastic sealing ring, of each plate-shaped pressing member and in a thickness direction of the plate-shaped pressing member. Alternatively, the vacuumizing interface and the vacuumizing channel are provided on a side edge of a certain plate-shaped pressing member.

### Embodiment 7

On the basis of Embodiment 5, a vacuumizing interface and a vacuumizing channel are respectively arranged on a side wall of at least one plate-shaped pressing member of each pressing layer, and all the vacuumizing interfaces are connected to a vacuum device. For example, in a laminator with three pressing layers, vacuumizing interfaces and vacuumizing channels are respectively arranged on side edges of a top-layer plate-shaped pressing member and second-layer and third-layer plate-shaped pressing members. When a laminator is closed, chambers of all pressing layers are independently sealed and may be independently vacuumized.

### Embodiment 8

As shown in Fig. 3, based on a structure of the apparatus of each item of Embodiments 1-7, one side of each plate-shaped pressing member is provided with a driving shaft 402 and a driving device, and the other side is provided with a driven shaft 404, a high-temperature resistant cloth conveyor belt 403 is arranged around the driving shaft and the driven shaft, the driving shaft is connected to the driving device, a tensioning air cylinder 405 is arranged on a plate-shaped pressing member on one side of the driven shaft, a cylinder body of the tensioning air cylinder is fixedly arranged on the plate-shaped pressing member, and a tension degree of the conveyor belt is adjusted through the tensioning air cylinder.

In a structure of each kind of embodiments above, the plate-shaped pressing member may be a flat plate, or a cooling plate with a heating device arranged in a plate body or a heating plate with a cooling device arranged in a plate body.

The high-temperature resistant cloth conveyor belt and a transmission device thereof are arranged so as to achieve automation of workpiece conveying-in and conveying-out.

### Embodiment 9: Multilayer laminator for vacuum heating curing of photovoltaic module

As shown in Fig. 3, a state of a plate pressing type laminator when a cover is opened is shown. A base 101 is a movable frame, and is arranged in a platform shape, and sealing strips 106 are arranged around an upper surface of the base. An upper cover 102 is a fixed frame, and is in a platform shape, and sealing strips 106 are also arranged around a lower surface of the upper cover. Three pressing layers are arranged between the upper cover and the base, and all layers of plate-shaped pressing members 401 are arranged opposite one another up and down. Working surfaces of an upper surface and a lower surface of the plate-shaped pressing member are generally planes, and are arranged to be surfaces matching a shape of a surface of a pressed battery module when the surface of the battery module is a special-shaped surface, such that lamination may proceed smoothly.

The plate-shaped pressing member is a heating plate, in which a heating device or a heating element is arranged. The heating plate is of the prior art and will not be described any more. A conveyor belt 403 uses a high-temperature resistant cloth conveyor belt, one end of the plate-shaped pressing member is provided with a driving shaft, and the other end is provided with a driven shaft. The high-temperature resistant cloth conveyor belt is arranged around the driving shaft 402 and the driven shaft 404 and tensioned by a tensioning air cylinder 405. A width of the conveyor belt is smaller than that of the plate-shaped pressing member but larger than that of the pressed photovoltaic module, such that each photovoltaic module is carried by the conveyor belt and covered with the conveyor belt above when the laminator is closed. In this way, a completely isolated space will not be formed between adjacent plate-shaped pressing members due to existence of the conveyor belt, and at least air between two adjacent plate-shaped pressing members circulates. An inflatable sealing ring as an elastic sealing member 406 is arranged on a lower surface of each upper plate-shaped pressing member and outside a working surface of the plate-shaped pressing member, the elastic sealing member is arranged at the peripheral edge of each plate-shaped pressing member 401, one part of the elastic sealing member is located in a sealed groove and the other part is located outside the sealed groove and higher than the plate-shaped pressing member. Certainly, if a height of the pressed module is relatively thick, the elastic sealing member is not high enough to form a chamber for accommodating the pressed module, and a concave chamber or a side frame may be arranged below the plate-shaped pressing member to make up for the shortage of the height of the elastic sealing member. When a press frame is arranged, the sealing ring is arranged on a lower surface of the side frame, two adjacent plate-shaped pressing members are connected in a sealed manner through the elastic sealing member, such that the pressed module is accommodated between the upper plate-shaped pressing member and the lower plate-shaped pressing member.

In this structure, the upper plate-shaped pressing member plays a role in supporting a workpiece on an upper surface thereof and heating the workpiece on one hand, and plays a role in pressing a workpiece below and heating the workpiece on the other hand. Since no membrane is arranged between the workpiece and the plate-shaped pressing member, a thin conveyor belt 403 is arranged therebetween for separation, heat conduction efficiency is high. The plate-shaped pressing member 401 may heat the two layers of modules located above and below at the same time and almost directly transfer the heat to the modules, such that efficiency of heat utilization of the plate-shaped pressing member is high. The plate-shaped pressing member located at the topmost layer only plays a pressing role, but has no supporting role. The upper cover 102 is above a top-layer plate-shaped pressing member, and a bottom-layer plate-shaped pressing member plays a supporting role. The upper cover 102 and the base 101 sandwich three pressing layers, and play the roles of pressure applying, support and heat preservation during lamination. Certainly, a top working layer may also use another structure. For example, the top working layer only includes a plate-shaped pressing member, an elastic sealing member is arranged above the plate-shaped pressing member, a conveyor belt, a driving shaft and a driven shaft are omitted. Consequently, although the conveyor belt does not isolate glue, such a structure may still be used without affecting the lamination effect. Alternatively, it is also a feasible embodiment to directly arrange a plate-shaped pressing member on the upper cover.

Four upright posts 103 are arranged on a left side and a right side of the frame 100, each upright post is provided with four baffle blocks along a height of the upright post for severing as cover opening support devices 104, and the baffle blocks on the four upright posts are arranged at the same height. Four lamination working layers are respectively located on the baffle blocks from a first layer to a fourth layer, and the baffle blocks of the corresponding layers support the plate-shaped pressing members of the corresponding layers. A slide rail is arranged on each upright post, a slide block is arranged on each layer of plate-shaped pressing member, and the plate-shaped pressing member is slidably connected to the upright post through a slide structure consisting of the slide rail and the slide block. In this embodiment, a lift oil cylinder/air cylinder 301 is selected as a lift driving device 300, and each upright post 103 is fixedly provided with the lift oil cylinder/air cylinder 301, a cylinder rod of each lift oil cylinder/air cylinder is connected to the base 101 through a lift frame 105. A cylinder body of the lift oil cylinder/air cylinder 301 is fixedly arranged on the upright post, and two jacking oil cylinders/air cylinders are respectively fixedly arranged on a left side surface and a right side surface of the base 101 to serve as closing positioning and supporting devices, each jacking oil cylinder/air cylinder respectively includes a second jacking oil cylinder/air cylinder 201A and a third jacking oil cylinder/air cylinder 201B, a cylinder rod of the third jacking oil cylinder/air cylinder 201B is higher than a cylinder rod of the second jacking oil cylinder/air cylinder 201. Second jacking blocks 203A are arranged on side surfaces of a left side and a right side of a plate-shaped pressing member of a second lamination working layer, a third jacking block 203B is arranged on a third plate-shaped pressing member of a third lamination working layer, the second jacking block corresponds to the cylinder rod of the second jacking oil cylinder/air cylinder in position, and the third jacking block corresponds to the cylinder rod of the third jacking oil cylinder/air cylinder in position. When each lamination working layer 400, the upper cover 102 and the base 101 are closed, the cylinder rod of the third jacking air cylinder jacks the third jacking block, the cylinder rod of the second jacking air cylinder jacks the second jacking block. Three telescopic oil cylinders/air cylinders 202 are respectively arranged on a left side and a right side of the upper cover 102 as supporting devices for the top-layer plate-shaped pressing member and a device carried thereon, and a cylinder rod of the telescopic oil cylinder/air cylinder 202 is fixedly connected to the top-layer plate-shaped pressing member 401. Certainly, the telescopic oil cylinder/air cylinder may also be replaced with the jacking oil cylinder/air cylinder. However, tensioning of the top-layer plate-shaped pressing member by the telescopic oil cylinder/air cylinder has the following advantages compared with supporting by using the jacking air cylinder. Since the upper cover is fixed, gravity of the top-layer plate-shaped pressing member and gravity of the device carried thereon are shared by the upper cover, which may reduce a load of the base. A synchronization device is arranged to make each layer of plate-shaped pressing member synchronously ascend and descend. The upper cover is provided with a vacuumizing pipeline and a vacuum interface, which are in communication with a vacuum device (not shown in the figure), and a vent hole 407 is provided at an edge position in the plate-shaped pressing member and located on the elastic sealing member, such that space formed between all the lamination working layers are in communication with one another. For the convenience of description, each plate-shaped pressing member and the device carried thereof such as a conveyor belt, a transmission shaft, a transmission shaft driving device and a tension air cylinder are collectively referred to as a lamination working layer.

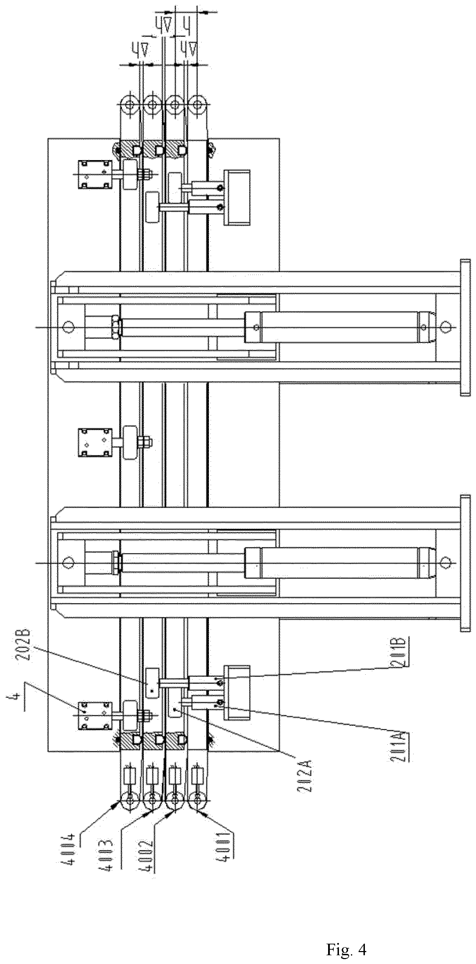

As shown in Fig. 3 and Fig. 4, when each pressing layer is in an open state, each layer of plate-shaped pressing member is supported by the cover opening support device, a distance between all layers of plate-shaped pressing members is H, a height of each layer of plate-shaped pressing member corresponds to that of a material table or lamination section butted front and back in actual production, materials of each layer are transported to the plate-shaped pressing member 401 of the corresponding layer by a conveyor belt 403 of each layer, the lift oil cylinder/air cylinder 3 moves to push the base 101 to ascend, so as to push a bottom lamination working layer 4001 to ascend, and the bottom-layer plate-shaped pressing member 4011 is attached to a sealing strip 106 of the base. At the same time, the telescopic oil cylinder/air cylinder retracts to make the top-layer plate-shaped pressing member 401 to attach to the sealing strip 106 of the upper cover 102. The second jacking air cylinder 201A outputs thrust greater than gravity of the second lamination working layer 4002, and the third jacking air cylinder 201B outputs thrust greater than gravity of the third lamination working layer 4003. When the cylinder rod of the lift oil cylinder/air cylinder 3 ascends to a designated position, the cylinder rod of the second jacking oil cylinder/air cylinder 201A comes into contact with the second jacking block 203A and supports the second lamination working layer 4002. The cylinder rod of the third jacking oil cylinder/air cylinder 201B comes into contact with the third jacking block 203B and supports the third lamination working layer 4003. At this time, a distance between the lamination working layers is h, and a distance Δh between the plate-shaped pressing members of the two adjacent lamination working layers is greater than a thickness of a conventional maximum thickness module. Moreover, the inflatable sealing ring of each layer may produce effective sealing, and the laminator enters the closed state.

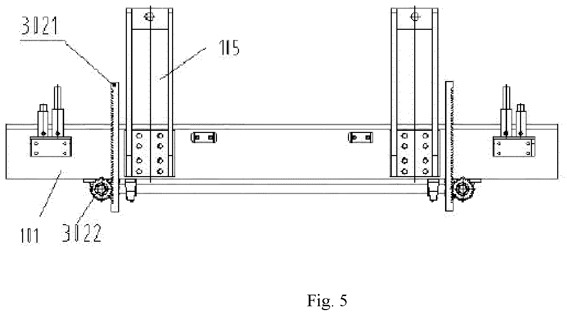

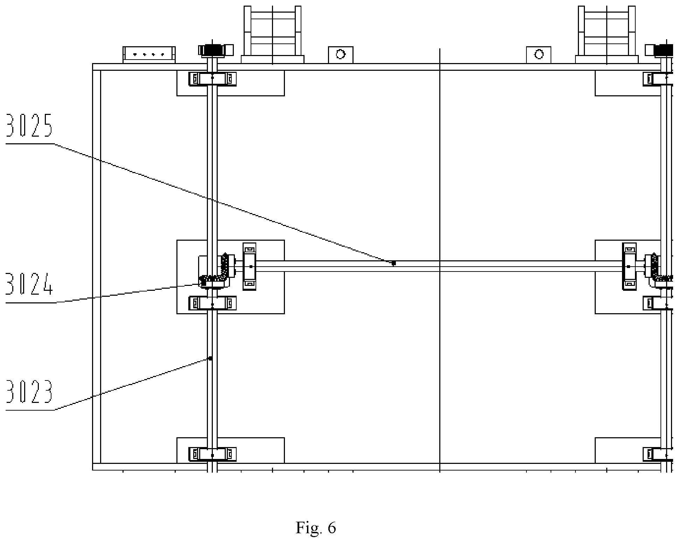

At present, a thickness of a conventional module is no greater than 15 mm generally, which may change with changes of products. After the laminator enters a closed state, a chamber for accommodating a module is formed between the plate-shaped pressing members of two adjacent lamination working layers, and Δh is a height of the chamber. In this state, the upper cover and the top-layer plate-shaped pressing member are sealed by the sealing strip, the base and the bottom-layer plate-shaped pressing member are sealed by the sealing strip, all layers are sealed by the elastic sealing member, and the whole laminator forms a sealed chamber. Although the plate-shaped pressing member is arranged in each layer, the plate-shaped pressing member is provided with the vent hole 407, so the whole inner chamber of the multi-layer laminator communicates. When the laminator enters the closed state, the plate-shaped pressing member of each layer ascends in place, and performs heating and curing on the module after ascending and descending in place. When a curing temperature is reached, gas left between the modules is pumped out by a vacuumizing device, and then lamination is performed. During lamination, the second jacking oil cylinder/air cylinder 201A outputs thrust equal to gravity of the second lamination working layer 4002, the third jacking oil cylinder/air cylinder 201B outputs thrust equal to gravity of the third lamination working layer 4003. The telescopic oil cylinder/air cylinder exerts pulling force equal to gravity of the top lamination working layer 4003 to offset a pressure on the products caused by the gravity of each upper lamination working layer, the cylinder rod of the lift oil cylinder/air cylinder 3 continues to ascend, such that the module comes into contact with the upper and lower plate-shaped pressing members and a lamination pressure is produced. The output thrust of the lift oil cylinder/air cylinder 3 depends on a lamination process and is equal to a pressure required to be applied to the module. All the lift oil cylinders/air cylinders move synchronously through the synchronization device 302. As shown in Figs. 5 and 6, a rack-and-pinion synchronization device is used, in which two gear shafts are arranged side by side front and back, and are adapted to the oil cylinder in position. A front end and a rear end of the gear shaft 3023 are respectively connected to gears 3022, and each upright post is correspondingly provided with a rack 3021, the gear and the rack are in meshing transmission connection, the gear shaft is fixedly connected to the base, an intermediate transmission shaft 3025 is arranged between the two gear shafts 3023, and both ends of the intermediate transmission shaft are respectively in meshing transmission connection to the gear shaft on a corresponding side through bevel gears 3024. Certainly, a hydraulic synchronization device may also be used, which is a common synchronization device used in the prior art and will not be described any more.

### Embodiment 10: Laminator for Cold Pressing of Photovoltaic Module

A structure is basically the same as that of Embodiment 9 except a difference that a plate-shaped pressing member is a cooling plate provided with a cooling medium, a pipeline and an interface for vacuumizing may be arranged, the pipeline and the interface for vacuumizing may not be arranged when vacuumizing is not needed before lamination, in which cooling and pressure applying may be directly performed.

### Embodiment 11

As another modified structure for design in Embodiments 9 and 10 of the present invention, a chamber of each lamination working layer may be independently vacuumized. At this time, it is not necessary to arrange a vacuumizing interface and pipeline on an upper cover, but a vacuumizing interface is arranged on a plate-shaped pressing member of each lamination working layer, for example, the vacuumizing interface is arranged on a side wall of the plate-shaped pressing member, and the vacuumizing pipeline is also arranged on the side wall of the plate-shaped pressing member, and is in communication with the vacuumizing interface and an inner chamber of the chamber. A lamination pressure is finely adjusted based on size of force output by a supporting device.

Using a laminator with a structure of the above embodiments of the present invention, the number of pressing layers may be set according to different production scales, for example, two lamination working layers may be set, in this case, one working chamber may be formed to laminate a workpiece, or more layers of lamination working layers may be arranged. There is no limit to the number of working layers, which may provide as much production capacity as possible in limited space. Moreover, all layers may be closed and laminated at the same time, which may greatly improve the efficiency of lamination work and multiply productivity of one apparatus. In addition, when hot pressing or cooling is performed, since the workpiece is located between an upper-layer plate-shaped pressing member and a lower-layer plate-shaped pressing member, both surfaces of the workpiece are heated or cooled at the same time, and are heated or cooled uniformly, through which uniform and rapid heating or cooling may be achieved, and the production efficiency may be also improved. During lamination, an upper cover and a base serve as pressure applying parts, an oil cylinder/air cylinder serves as a force output device, the workpiece is pressed through pressure between the upper cover and base, a pressure on the workpiece, that is, a pressure on a surface of the workpiece is adjusted by adjusting an output pressure of the oil cylinder/air cylinder, and the lift oil cylinder/air cylinder is wide in range of the output pressure and convenient and rapid in pressure adjustment.

In the present invention, when a laminated module is a plane, in the most preferred scheme, the plate-shaped pressing member of each lamination working layer, the upper cover and the base are all plate-shaped structures, and the sealing strip 106 merely serves as a sealing member but not as a pressure-bearing member, and is located in the sealed groove during lamination. All the elastic sealing members are all inflatable sealing rings, and play a role in adapting to deformation under different pressures, which not only form seals between adjacent plate-shaped pressing members, but also adapt to different pressures, such that an output pressure of the oil cylinder/air cylinder is directly transmitted to the module, and pressure loss between the output pressure and pressure suffered by the workpiece is less.

In the present invention, when the module is subjected to pressure applying, the plate-shaped pressing member between the upper cover and the base is pressed, and the plate-shaped pressing member transmits the pressure to the module. Since a shape of a surface of the plate-shaped pressing member matches a shape of a surface of a laminated workpiece, the surface of the plate-shaped pressing member is in full contact with the surface of the workpiece, such that the heat transmission effect is good, the pressure applying is uniform, and the workpiece is not prone to warp.

The laminator of the present invention may be arranged at different stations of a lamination working line, and is preferably used as a first chamber of a lamination process for hot pressing and curing. The laminator may match and be combined with any kind of laminator on a production line.

In the present invention, in order to reduce a breakage rate of the workpiece, a flexible pad is arranged below the plate-shaped pressing member, such as a fabric and a rubber pad, with a general thickness of 1-10 mm.

In the present invention, the closing positioning and supporting device and the lift driving device may also adopt the air cylinder, a lifting pulley, hoist, etc. It is better to use the inflatable sealing ring as the elastic sealing strip. The advantage of using the inflatable sealing ring is that different workpieces may be inflated with gas with different pressures, such that the pressure of plate-shaped pressing member is buffered.

## Claims

1. A plate pressing type laminator comprising a lift driving device (300) and a plurality of plate-shaped pressing members (401) which are sequentially arranged from top to bottom, wherein a chamber for accommodating a workpiece is formed in a space between every two adjacent plate-shaped pressing members when they are pressed against each other, the chamber forming a pressing layer; and the lift driving device (300) drives the plurality of plate-shaped pressing members (401) to press against one another or move away from one another and provides a pressure for mutual pressing, and the workpiece is pressed through the pressure between the plate-shaped pressing members;
and the laminator is provided with a vacuumizing interface and a vacuumizing channel, the vacuumizing interface and the vacuumizing channel for being connected to a vacuumizing device, so as to vacuumize the chamber;
it further comprises an upper cover (102), a base (101) and an upright post (103), wherein the upper cover is located above an uppermost plate-shaped pressing member, the base is located below a lowermost plate-shaped pressing member, and each plate-shaped pressing member is connected to the upright post in an up-and-down sliding manner through a sliding connection structure;
the lift driving device drives the upper cover and the base to get close to each other to drive the plate-shaped pressing members to press against one another, so as to enable the pressing layers to be closed for pressing;
an elastic member (406) is arranged between adjacent plate-shaped pressing members, wherein the elastic member is an elastic sealing member, and when the adjacent plate-shaped pressing members press against each other, the elastic member completely or intermittently seals the chamber formed by the space between the adjacent plate-shaped pressing members;
the laminator further comprising
a closing positioning and supporting device (200), which supports each plate-shaped pressing member when the pressing layer is closed;
wherein the closing positioning and supporting device of a plate-shaped pressing member located in the middle comprises a jacking block (203) and a jacking oil cylinder or air cylinder (201), a cylinder body of the jacking oil cylinder or air cylinder is fixedly arranged on the base, the jacking block (203) is respectively arranged in a position corresponding to the jacking oil cylinder or air cylinder, on each plate-shaped pressing member located in the middle, and when the pressing layers are closed, a cylinder rod of the jacking oil cylinder or air cylinder jacks the jacking block of the corresponding plate-shaped pressing member; and
the closing positioning and supporting device of the uppermost plate-shaped pressing member comprises an oil cylinder or an air cylinder (202), a cylinder body of the oil cylinder or the air cylinder being fixedly arranged on the upper cover, and a cylinder rod of the oil cylinder or the air cylinder being fixedly connected to the uppermost plate-shaped pressing member.

2. The plate pressing type laminator according to claim 1, **characterized in that**, the vacuumizing interface is arranged on any plate-shaped pressing member (401), the plate-shaped pressing member provided with the vacuumizing interface is provided with the vacuumizing channel, and each plate-shaped pressing member located between the uppermost plate-shaped pressing member and the lowermost plate-shaped pressing member is provided with a vent hole (407) at an inner side of the elastic sealing member.

3. The plate pressing type laminator according to claim 1, **characterized in that**, a first sealing member is arranged between the base and the lowermost plate-shaped pressing member, a second sealing member is arranged between the upper cover and the uppermost plate-shaped pressing member, when the pressing layers are closed, a gap between the base and the lowermost plate-shaped pressing member is sealed by the first sealing member, a gap between the upper cover and the uppermost plate-shaped pressing member is sealed by the second sealing member, the vacuumizing interface and the vacuumizing channel are arranged on the base and/or the upper cover, and a vent hole is provided on each plate-shaped pressing member between the base and the upper cover at an inner side of the elastic sealing member.

4. The plate pressing type laminator according to claim 1, **characterized in that**, after the plate-shaped pressing members are separated, each plate-shaped pressing member located between the uppermost plate-shaped pressing member and the lowermost plate-shaped pressing member is supported by a cover opening support device (104) for each plate-shaped pressing member.

5. The plate pressing type laminator according to claim 1, **characterized in that**, the lift driving device is an oil cylinder or an air cylinder, a surface, opposite the plate-shaped pressing member, of the upper cover and a surface, opposite the plate-shaped pressing member, of the base are flat planes, the upper cover is fixedly arranged, and a cylinder body of the oil cylinder or the air cylinder is fixedly connected to the base.

6. The plate pressing type laminator according to claim 1, **characterized in that**, a sealed groove is provided at the periphery of a lower surface of the plate-shaped pressing member, and the elastic sealing member is an inflatable sealing ring, one end of inflatable sealing ring being located inside the sealed groove and the other end being located outside the sealed groove.

7. The plate pressing type laminator according to claim 1, **characterized in that**, two ends of each plate-shaped pressing member located below the uppermost plate-shaped pressing member are respectively provided with a driving shaft (402) and a driven shaft, and a conveyor belt (403) is arranged around the driving shaft and the driven shaft (404), and the conveyor belt is driven by a driving device to move around the plate-shaped pressing member; and/or
a heating or cooling device is arranged on the plate-shaped pressing member.

8. The plate pressing type laminator according to claim 1, **characterized in that**, a plurality of lift driving devices are arranged, and each lift driving device realizes synchronous movement through a synchronization device (302), and the lift driving device (300) is a lift oil cylinder or air cylinder (301).

9. A pressure applying method, using the plate pressing type laminator according to any one of claims 1-8, the method comprising: placing a plate-shaped workpiece between adjacent plate-shaped pressing members, and driving, through the lift driving device, the plate-shaped pressing members to get close to and press one another to apply a pressure to the workpiece.

## Patentansprüche

1. Platten-Presslaminator, der eine Hebe-Antriebsvorrichtung (300) sowie eine Vielzahl plattenförmiger Presselemente (401) umfasst, die von oben nach unten aufeinanderfolgend angeordnet sind, wobei eine Kammer zum Aufnehmen eines Werkstücks in einem Raum zwischen jeweils zwei benachbarten plattenförmigen Presselementen ausgebildet wird, wenn sie aneinandergepresst werden, und die Kammer eine Pressschicht bildet, und die Hebe-Antriebsvorrichtung (300) die Vielzahl plattenförmiger Presselemente (401) so antreibt, dass sie aneinandergepresst werden oder sich voneinander weg bewegen, und einen Druck zum wechselseitigen Pressen erzeugt, und das Werkstück mittels des Drucks zwischen den plattenförmigen Presselementen gepresst wird;
und der Laminator mit einer Vakuumerzeugungs-Grenzfläche sowie einem Vakuumerzeugungs-Kanal versehen ist, wobei die Vakuumerzeugungs-Grenzfläche und der Vakuumerzeugungs-Kanal dazu bestimmt sind, mit einer Vakuumerzeugungs-Vorrichtung verbunden zu werden, um in der Kammer Vakuum zu erzeugen;
wobei er des Weiteren eine obere Abdeckung (102), eine Basis (101) sowie eine senkrechte Stütze (103) umfasst, die obere Abdeckung sich zwischen einem obersten plattenförmigen Presselement befindet, sich die Basis zwischen einem untersten plattenförmigen Presselement befindet und jedes plattenförmige Presselement über eine gleitende Verbindungsstruktur so mit der senkrechten Stütze verbunden ist, dass es nach oben und nach unten gleitet;
die Hebe-Antriebsvorrichtung die obere Abdeckung und die Basis so antreibt, dass sie sich einander nähern und die plattenförmigen Presselemente so antreiben, dass sie aneinandergepresst werden, um zu ermöglichen, dass die Pressschichten zum Pressen geschlossen werden;
wobei ein elastisches Element (406) zwischen benachbarten plattenförmigen Presselementen angeordnet ist, das elastische Element ein elastisches Dichtungselement ist und wenn die benachbarten plattenförmigen Dichtungselemente aneinandergepresst werden, das elastische Element die durch den Raum zwischen den benachbarten plattenförmigen Presselementen gebildete Kammer vollständig oder mit Unterbrechungen abdichtet;
und der Laminator des Weiteren umfasst:
eine Vorrichtung (200) zum Positionieren und Tragen im geschlossenen Zustand, die jedes plattenförmige Presselement trägt, wenn die Pressschicht geschlossen ist;
wobei die Vorrichtung zum Positionieren und Tragen im geschlossenen Zustand eines in der Mitte befindlichen plattenförmigen Presselementes einen Hebeblock (203) sowie einen Hebe-Ölzylinder oder -Luftzylinder (201) umfasst, ein Zylinderkörper des Hebe-Ölzylinders oder -Luftzylinders fest an der Basis angeordnet ist; der Hebeblock (203) jeweils an einer Position, die dem Hebe-Ölzylinder oder -Luftzylinder entspricht an jedem in der Mitte befindlichen plattenförmigen Presselement angeordnet ist, und, wenn die Pressschichten geschlossen sind, eine Zylinderstange des Hebe-Ölzylinders oder -Luftzylinders den Hebeblock des entsprechenden plattenförmigen Presselementes anhebt; und
die Vorrichtung zum Positionieren und Tragen im geschlossenen Zustand des obersten plattenförmigen Presselementes einen Ölzylinder oder einen Luftzylinder (202) umfasst, ein Zylinderkörper des Ölzylinders oder des Luftzylinders fest an der oberen Abdeckung angeordnet ist und eine Zylinderstange des Ölzylinders oder des Luftzylinders fest mit dem obersten plattenförmigen Presselement verbunden ist.

2. Platten-Presslaminator nach Anspruch 1, **dadurch gekennzeichnet, dass** die Vakuumerzeugungs-Grenzfläche an jedem beliebigen plattenförmigen Presselement (401) angeordnet ist, wobei das mit der Vakuumerzeugungs-Grenzfläche versehene plattenförmige Presselement mit dem Vakuumerzeugungs-Kanal versehen ist und jedes plattenförmige Presselement, das sich zwischen dem obersten plattenförmigen Presselement und dem untersten plattenförmigen Element befindet, mit einem Luftloch (407) an einer Innenseite des elastischen Dichtungselementes versehen ist.

3. Platten-Presslaminator nach Anspruch 1, **dadurch gekennzeichnet, dass** ein erstes Dichtungselement zwischen der Basis und dem untersten plattenförmigen Presselement angeordnet ist, ein zweites Dichtungselement zwischen der oberen Abdeckung und dem obersten plattenförmigen Presselement angeordnet ist, wenn die Pressschichten geschlossen sind, ein Zwischenraum zwischen der Basis und dem untersten plattenförmigen Presselement durch das erste Dichtungselement abgedichtet wird, ein Zwischenraum zwischen der oberen Abdeckung und dem obersten plattenförmigen Presselement durch das zweite Dichtungselement abgedichtet wird, die Vakuumerzeugungs-Grenzfläche und der Vakuumerzeugungs-Kanal an der Basis und/oder der oberen Abdeckung angeordnet sind und ein Luftloch an jedem plattenförmigen Presselement zwischen der Basis und der oberen Abdeckung an einer Innenseite des elastischen Dichtungselementes vorhanden ist.

4. Platten-Presslaminator nach Anspruch 1, **dadurch gekennzeichnet, dass,** nachdem die plattenförmigen Presselemente getrennt sind, jedes plattenförmige Presselement, das sich zwischen dem obersten plattenförmigen Presselement und dem untersten plattenförmigen Presselement befindet, von einer Vorrichtung (104) zum Tragen im geöffneten Zustand der Abdeckung für jedes plattenförmige Presselement getragen wird.

5. Platten-Presslaminator nach Anspruch 1, **dadurch gekennzeichnet, dass** die Hebe-Antriebsvorrichtung ein Ölzylinder oder ein Luftzylinder ist, eine dem plattenförmigen Presselement gegenüberliegende Fläche der oberen Abdeckung und eine dem plattenförmigen Presselement gegenüberliegende Fläche der Basis ebene Flächen sind, die obere Abdeckung fest angeordnet ist und ein Zylinderkörper des Ölzylinders oder des Luftzylinders fest mit der Basis verbunden ist.

6. Platten-Presslaminator nach Anspruch 1, **dadurch gekennzeichnet, dass** eine abgedichtete Nut an dem äußeren Rand einer unteren Fläche des plattenförmigen Presselementes vorhanden ist und das elastische Dichtungselement ein aufblasbarer Dichtungsring ist, wobei sich ein Ende des aufblasbaren Dichtungselementes innerhalb der abgedichteten Nut befindet und sich das andere Ende außerhalb der abgedichteten Nut befindet.

7. Platten-Presslaminator nach Anspruch 1, **dadurch gekennzeichnet, dass** zwei Enden jedes plattenförmigen Presselementes, das sich unterhalb des obersten plattenförmigen Presselementes befindet, jeweils mit einer antreibenden Welle (420) und einer angetriebenen Welle versehen sind, ein Förderband (403) um die antreibende Welle und die angetriebene Welle (404) herum angeordnet ist und das Förderband von einer Antriebsvorrichtung so angetrieben wird, dass es sich um das plattenförmige Presselement herum bewegt, und/oder eine Heiz- oder Kühlvorrichtung an dem plattenförmigen Presselement angeordnet ist.

8. Platten-Presslaminator nach Anspruch 1, **dadurch gekennzeichnet, dass** eine Vielzahl von Hebe-Antriebsvorrichtungen vorhanden sind und jede Hebe-Antriebsvorrichtung synchrone Bewegung über eine Synchronisationsvorrichtung (302) durchführt und die Hebe-Antriebsvorrichtung (300) ein Hebe-Ölzylinder oder-Luftzylinder (301) ist.

9. Verfahren zum Aufbringen von Druck unter Einsatz des Platten-Presslaminators nach einem der Ansprüche 1 - 8, wobei das Verfahren umfasst, dass ein plattenförmiges Werkstück zwischen benachbarten plattenförmigen Presselementen positioniert wird und die plattenförmigen Presselemente mittels der Hebe-Antriebsvorrichtung so angetrieben werden, dass sich die plattenförmigen Presselemente einander annähern und pressen und einen Druck auf das Werkstück aufbringen.

## Revendications

1. Machine à stratifier de type à pressage de plaques comprenant un dispositif d'entraînement de levée (300) et une pluralité d'éléments de pressage en forme de plaques (401) qui sont disposés séquentiellement du sommet à la base, un compartiment qui permet d'accueillir une pièce à usiner étant formé dans un espace situé entre deux éléments de pressage adjacents en forme de plaques lorsqu'ils sont pressés l'un contre l'autre, le compartiment formant une couche de pressage ; et le dispositif d'entraînement de levée (300) entraîne la pluralité d'éléments afin de les comprimer l'un contre l'autre ou les éloigner l'un de l'autre et il délivre une pression permettant un pressage mutuel, et la pièce à usiner est pressée grâce à la pression régnant entre les éléments de pressage en forme de plaques,
et la machine stratifiée est dotée d'une interface de mise sous vide et d'un canal de mise sous vide, l'interface de mise sous vide et le canal de mise sous vide étant reliés à un dispositif de mise sous vide de sorte à faire le vide dans le compartiment,
elle comprend en outre un couvercle supérieur (102), une base (101) et un montant vertical (103), le couvercle supérieur étant situé par-dessus l'élément de pressage en forme de plaque le plus haut, la base étant située en dessous de l'élément de pressage en forme de plaque le plus bas et chaque élément de pressage en forme de plaque étant relié au montant vertical de façon à coulisser vers le haut et le bas grâce à une structure de raccordement coulissante,
le dispositif d'entraînement de levée entraîne le couvercle supérieur et la base afin de les rapprocher de façon à entraîner les éléments de pressage en forme de plaques pour les presser l'un contre l'autre de sorte à permettre le rapprochement des couches de pressage en vue du pressage,
un élément élastique (406) est disposé entre des éléments de pressage adjacents en forme de plaques, l'élément élastique étant un élément d'étanchéité élastique, et lorsque les éléments de pressage adjacents en forme de plaques sont pressés l'un contre l'autre, l'élément élastique rend étanche complètement ou de façon intermittente le compartiment formé par l'espace situé entre les éléments de pressage adjacent en forme de plaques,
la machine stratifiée comprend en outre :
un dispositif de positionnement de rapprochement et de support (200) qui soutient chaque élément de pressage en forme de plaque lorsque la couche de pressage est proche,
dans laquelle le dispositif de positionnement de rapprochement et de support d'un élément de pressage en forme de plaque situé au milieu comprend un bloc de levage (203) et un vérin hydraulique ou un vérin pneumatique de levage (201) le corps cylindrique du vérin hydraulique ou du vérin pneumatique de levage est disposé à demeure sur la base, le bloc de levage (203) est disposé respectivement dans une position correspondant au vérin hydraulique ou au vérin pneumatique de levage sur chaque élément de pressage en forme de plaque situé au milieu, et lorsque les couches de pressage sont proches, une tige cylindrique du vérin hydraulique ou du vérin pneumatique de levage élève le bloc de levage de l'élément correspondant de pressage en forme de plaque, et
le dispositif de positionnement de rapprochement et de support de l'élément de pressage en forme de plaque le plus haut comprend un vérin hydraulique ou un vérin pneumatique (202), le corps cylindrique du vérin hydraulique ou du vérin pneumatique étant disposé à demeure sur le couvercle supérieur et la tige cylindrique du vérin hydraulique ou du vérin pneumatique étant reliée de façon fixe à l'élément de pressage en forme de plaque le plus haut.

2. Machine à stratifier de type à pressage de plaques selon la revendication 1, **caractérisée en ce que** l'interface de mise sous vide est disposée sur un quelconque élément de pressage en forme de plaque (401), l'élément de pressage en forme de plaque, doté de l'interface de mise sous vide, est muni du canal de mise sous vide, et chaque élément de pressage en forme de plaque situé entre l'élément de pressage en forme de plaque le plus haut et l'élément de pressage en forme de plaque le plus bas est muni d'un alésage de ventilation (407) du côté interne de l'élément élastique d'étanchéité.

3. Machine à stratifier de type à pressage de plaques selon la revendication 1, **caractérisée en ce qu'**un premier élément d'étanchéité est disposé entre la base et l'élément de pressage en forme de plaque le plus bas, un second élément d'étanchéité est disposé entre le couvercle supérieur et l'élément de pressage en forme de plaque le plus haut, lorsque les couches de pressage sont rapprochées, l'intervalle entre la base et l'élément de pressage en forme de plaque le plus bas est rendu étanche par le premier élément d'étanchéité, l'intervalle entre le couvercle supérieur et l'élément de pressage en forme de plaque le plus haut est rendu étanche par le second élément d'étanchéité, l'interface de mise sous vide et le canal de mise sous vide sont disposés sur la base et/ou sur le couvercle supérieur et un alésage de ventilation est prévu sur chaque élément de pressage en forme de plaque entre la base et le couvercle supérieur du côté interne de l'élément élastique d'étanchéité.

4. Machine à stratifier de type à pressage de plaques selon la revendication 1, **caractérisée en ce que**, après que les éléments de pressage en forme de plaques ont été séparés, chaque élément de pressage en forme de plaque situé entre l'élément de pressage en forme de plaque le plus haut et l'élément de pressage en forme de plaque le plus bas est supporté par un dispositif de support d'ouverture de couvercle (104) pour chaque élément de pressage en forme de plaque.

5. Machine à stratifier de type à pressage de plaques selon la revendication 1, **caractérisée en ce que** le dispositif d'entraînement de levée est un vérin hydraulique ou un vérin pneumatique, la surface opposée à l'élément de pressage en forme de plaque du couvercle supérieur et la surface opposée à l'élément de pressage en forme de plaque de la base sont des plaques planes, le couvercle supérieur est disposé à demeure et le corps cylindrique du vérin hydraulique ou du vérin pneumatique est relié de façon fixe à la base.

6. Machine à stratifier de type à pressage de plaques selon la revendication 1, **caractérisée en ce qu'**une rainure étanche est prévue à la périphérie de la surface inférieure de l'élément de pressage en forme de plaque et **en ce qu'**un élément élastique d'étanchéité est une bague gonflable d'étanchéité, une première extrémité de la bague gonflable étanchéité étant située à l'intérieur de la rainure étanche et l'autre extrémité étend située à l'extérieur de la rainure étanche.

7. Machine à stratifier de type à pressage de plaques selon la revendication 1, **caractérisée en ce que** deux extrémités de chaque élément de pressage en forme de plaque situé en dessous de l'élément de pressage en forme de plaque le plus haut sont dotés respectivement d'un arbre d'entraînement (402) et d'un arbre entraîné, et une courroie de transport (403) est disposée autour de l'arbre d'entraînement et de l'arbre entraîné (400), et la courroie de transport est entraînée par un dispositif d'entraînement afin de se déplacer autour de l'élément de pressage en forme de plaque, et/ou
un dispositif de chauffage ou de refroidissement est disposé sur l'élément de pressage en forme de plaque.

8. Machine à stratifier de type à pressage de plaques selon la revendication 1, **caractérisée en ce que** plusieurs dispositifs d'entraînement de levée sont disposés, et chaque dispositif d'entraînement de levée effectue un mouvement synchrone grâce à un dispositif de synchronisation (302), et le dispositif d'entraînement de levée (300) et un vérin hydraulique ou un vérin pneumatique de levée (301).

9. Procédé d'application de pression en utilisant la machine à stratifier de type à pressage de plaques conforme à l'une quelconque des revendications 1 à 8, le procédé comprenant : le placement d'une pièce à usiner en forme de plaque entre des éléments de pressage adjacents en forme de plaque et l'entraînement, par l'intermédiaire du dispositif d'entraînement de levée, des éléments de pressage en forme de plaques dans le but de les rapprocher et de les presser l'un contre l'autre afin d'appliquer une pression sur la pièce à usiner.
